Europäisches Patentamt

(19) European Patent Office　(11) Numéro de publication: **0 012 667**

Office européen des brevets　**B1**

⑫　**FASCICULE DE BREVET EUROPEEN**

(45) Date de publication du fascicule de brevet: **23.09.81**　(51) Int. Cl.³: **H 03 H 19/00,**
　　　　　　　　　　　　　　　　　　　　　　　　**H 03 H 15/02**

(21) Numéro de dépôt: **79400962.1**

(22) Date de dépôt: **04.12.79**

(54) **Procédé de filtrage d'un signal électrique par transfert de charges dans un semi-conducteur et filtre à capacités commutées utilisant un tel procédé.**

(30) Priorité: **12.12.78 FR 7834881**

(43) Date de publication de la demande:
**25.06.80 Bulletin 80/13**

(45) Mention de la délivrance du brevet:
**23.09.81 Bulletin 81/38**

(84) Etats Contractants Désignés:
**DE GB NL**

(73) Titulaire: **THOMSON-CSF**
**173, Boulevard Haussmann**
**F-75360 Paris Cedex 08 (FR)**

(72) Inventeur: **Berger, Jean-Luc**
**"THOMSON-CSF" - SCPI 173, bld Haussmann**
**F-75360 Paris Cedex 08 (FR)**
Inventeur: **Coutures, Jean-Louis**
**"THOMSON-CSF" - SCPI 173, bld Haussmann**
**F-75360 Paris Cedex 08 (FR)**

(74) Mandataire: **Benichou, Robert et al,**
**"THOMSON-CSF" - SCPI 173 bld Haussmann**
**F-75360 Paris Cedex 08 (FR)**

(56) Documents cités:
**ARCHIV FÜR ELEKTRONIK UND UBERTRA-**
**GUNGSTECHNIK, vol. 32, n° 10, octobre 1978,**
**Stuttgart, DE**
**E. LUDER "Integrierbare Filter in VLSI Technik",**
**pages 381—389**

**IEEE JOURNAL OF SOLID STATE CIRCUITS, vol.**
**SC—12, n° 6, décembre 1977,**
**New York, US**
**J. T. CAVES et al. "Sampled analog filtering using**
**switched capacitors as resistor equivalents",**
**pages 592—599**

**IEEE JOURNAL OF SOLID STATE CIRCUITS, vol.**
**SC—12, n° 6, décembre 1977**
**New York, US**
**B. HOSTICKA et al. "MOS sampled data recursive**
**filters using switched capacitor integrators",**
**pages 600—608**

**1978 INTERNATIONAL CONFERENCE ON COM-**
**MUNICATIONS, vol. 3 (Toronto, Canada, juin**
**4—7, 1978)**
**IEEE Catalog n° 78 CH 1350—8 CSCB,**
**New York, US**
**M. A. COPELAND: "Some aspects of sampled-**
**analog MOS LSI circuits for communications",**
**pages 45.1.1 — 45.1.7**

Courier Press, Leamington Spa, England.

# 0012667

Procédé de filtrage d'un signal électrique par transfert de charges dans un semi-conducteur et filtre à capacités commutées utilisant un tel procédé.

La présente invention concerne un procédé de filtrage d'un signal électrique par transfert de charges dans un semi-conducteur. Elle se rapporte également aux filtres à cap acités commutées utilisant un tel procédé.

Des filtres actifs appelés filtres à capacités commutées sont connus, en particulier par deux articles de la revue américaine "IEEE Journal of solid-state circuits", volume SC—12, N° 6, décembre 1977, pages 592 à 608.

Les filtres à capacités commutées comportent généralement au moins un amplificateur associé à un réseau d'interrupteurs MOS et de capacités, dans lequel la combinaison de deux interrupteurs MOS et d'une capacité sert de résistance. L'encombrement des filtres à capacités commutées est faible, leur stabilité en température et leur linéarité sont importantes.

L'intégration des capacités des filtres à capacités commutées se fait, de façon connue, par une technologie à deux niveaux de métallisation. Chaque borne des capacités intégrées présente alors par rapport au substrat une capacité parasite de valeur non négligeable. Les capacités parasites créées sur les capacités du réseau associé à l'amplificateur sont particulièrement gênantes car elles introduisent des erreurs sur la réponse en fréquence du filtre. On est alors conduit à augmenter les valeurs des capacités du réseau pour diminuer l'effet des capacités parasites ce qui augmente la surface de substrat semi-conducteur nécessaire à la réalisation du filtre, et donc son coût et son encombrement.

Les filtres à capacités commutées utilisant le procédé de filtrage selon l'invention présentent l'avantage de ne pas comporter de capacités parasites sur les capacités du réseau associé à l'amplificateur, car ces capacités ne sont pas réalisées par la technologie à deux niveaux de métallisation, mais présentent une borne commune et la liaison entre ces capacités se fait par transfert de charges. On peut ainsi utiliser de faibles valeurs pour les capacités du réseau, et le coût et l'encombrement du filtre peuvant être diminués.

Le procédé de filtrate d'un signal électrique selon l'invention utilise le transfert de charges dans un substrat semi-conducteur, qui est recouvert d'une première couche isolante sur laquelle est disposée une première série d'électrodes, qui constituent avec la première couche isolante et le substrat des capacités de stockage des charges, une deuxième série d'électrodes est intercalée avec la première dont elle est séparée par une deuxième couche isolante, les électrodes de cette deuxième série constituant avec la première et la deuxième couche isolante et avec le substrat des interrupteurs qui commandent le transfert des charges entre les capacités de stockage. Dans le procédé selon l'invention le traitement de chaque échantillon du signal électrique d'entrée comporte les étapes suivantes:

a) on introduit sous la première capacité, selon le sens de transfert des charges, une quantité de charges correspondant à l'échantillon du signal eléctrique d'entrée en cours de traitement;

b) on introduit sous la dernière capacité, selon le sens de transfert des charges, une quantité de charges égale à celle qui s'y trouvait, lors du traitement de l'échantillon précédant du signal électrique d'entrée, avant que commence le transfert des charges de cette dernière capacité vers des moyens qui convertissent les charges en tension électrique;

c) on établit un potentiel de surface commun entre deux capacités successives, les capacités étant portées pendant cette étape à un potentiel constant $V_g$;

d) on transfère les charges de la dernière capacité, selon le sens de transfert des charges, vers des moyens qui convertissent les charges en tension électrique.

L'ordre des étapes a) et b) du procédé est quelconque, par contre les étapes a) et b) doivent précéder l'étape c), qui doit précéder l'étape d).

Dans le cas de filtres du deuxième ordre au moins, l'une des capacités de stockage assure le bouclage du filtre et le procédé comporte une étape e) supplémentaire. Au cours de cette étape, un potentiel de surface commun est établi entre la capacité qui assure le bouclage du filtre et la capacité suivante selon le sens de transfert des charges, ces capacités étant respectivement portées à des tensions $V_g + \Delta V_s$ et $V_g$, où $\Delta V_s$ est la variation de la tension de la sortie du filtre pour l'échantillon précédent du signal électrique d'entrée. L'ordre des étapes a), b) et e) est quelconque, par contre ces étapes doivent précéder l'étape c), qui doit précéder l'étape d).

D'autres objets, caractéristiques et résultats de l'invention ressortiront de la description suivante, donnée à titre d'exemple non limitatif, et illustrée par les figures annexées qui représentent:

— la figure 1, le schéma d'un filtre à capacités commutées du premier ordre, selon l'art connu;

— les figures 2a à 2f, un mode de réalisation selon l'invention du filtre de la figure 1 et des schémas illustrant le procédé de filtrage selon l'invention;

— la figure 3, des diagrammes de signaux susceptibles d'être appliqués au filtre de la figure 2;

— la figure 4, le schéma d'un filtre à capacités commutées du deuxième ordre, selon l'art connu;

— la figure 5, un mode de réalisation selon l'invention du filtre de la figure 4;

— la figure 6, des diagrammes de signaux susceptibles d'être appliqués au filtre de la figure 5;

— la figure 7, un autre mode de réalisation selon l'invention du filtre de la figure 4 et des schémas illustrant son fonctionnement.

**0 012 667**

Sur les différentes figures, les mêmes repéres désignent les mêmes éléments et pour des raisons de clartés, les cotes et proportions des différents éléments n'ont pas été respectées.

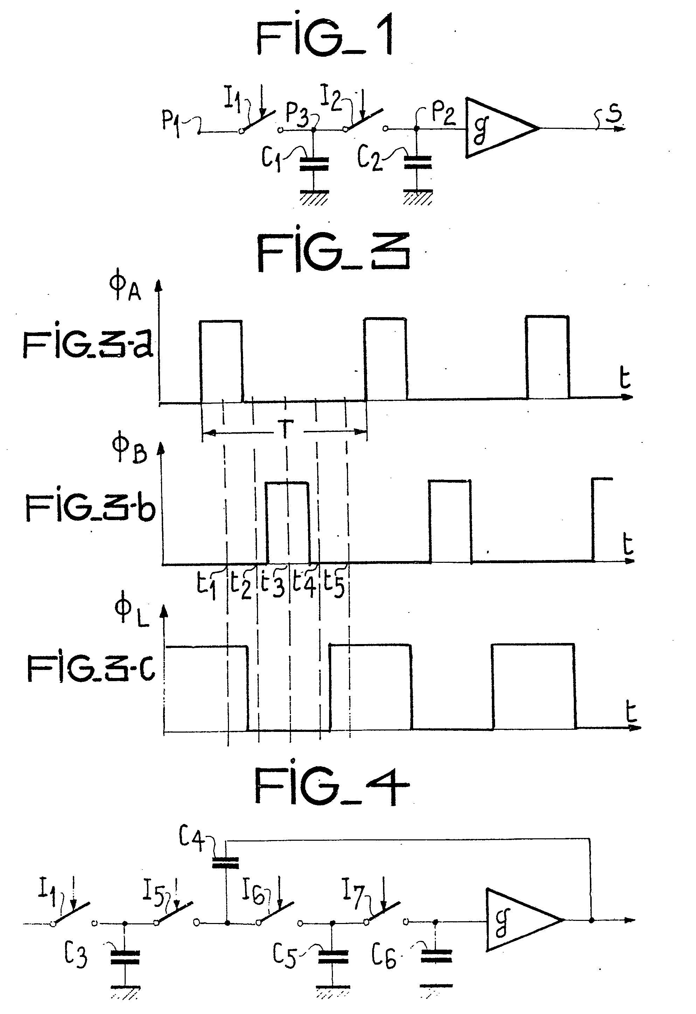

La figure 1 représente le schéma d'un filtre à capacités commutées du premier ordre selon l'art connu. Ce filtre, du type RC, comporte entre deux points $P_1$ et $P_2$ une résistance, réalisée par le mise en série de deux interrupteurs $I_1$ et $I_2$ et par une capacité $C_1$ entre le point commun $P_3$ de $I_1$ et $I_2$ et la masse. Ce filtre comporte aussi une capacité $C_2$ entre le point $P_2$ et la masse et un amplificateur de gain g entre le point $P_2$ et la sortie S de ce filtre.

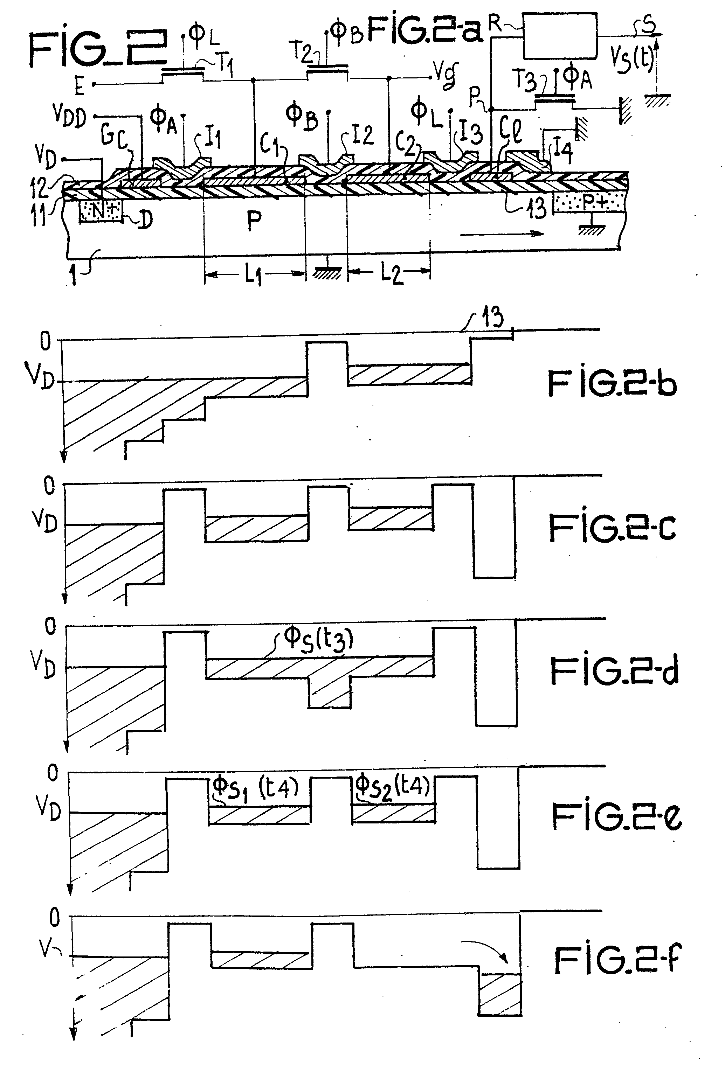

La figure 2a représente un mode da réalisation selon l'invention du filtre de la figure 1. Sur la figure 2a, on a représenté, vu en coupe, parallèlement au sens de transfert des charges, le réseau de capacités et d'interrupteurs MOS du filtre de la figure 1, on a également représenté la schéma du circuit électrique associé à ce réseau. Le filtre selon l'invention utilise le transfert de charges dans un substrat semi-conducteur 1, qui est recouvert d'une première couche isolante 11, sur laquelle est disposée une première série d'électrodes, qui créent avec la première couche isolante et le substrat des capacités de stockage des charges C. Une deuxième série d'électrodes est intercalée avec la première série dont elle est séparée par une deuxième couche isolante 12. Les électrodes de cette deuxième série constituent, avec la première et la deuxième couche isolantes et avec le substrat, des interrupteurs MOS I qui commandent le transfert des charges entre les capacités de stockage.

Le substrat semi-conducteur peut être en silicium, de type P par exemple et les deux séries d'électrodes peuvent être en silicium polycristallin. La deuxième couche isolante 12 est alors réalisée par oxydation du silicium polycristallin de la première série d'électrodes.

Le filtre représenté sur la figure 2a comporte deux capacités de stockage $C_1$ et $C_2$, entre lesquelles est intercalé un interrupteurs MOS $I_2$. Une grille $G_c$, située dans la même plan que les capacités $C_1$ et $C_2$, commande le courant délivré par une diode D implantée dans la substrat semi-conducteur et portée à un potentiel constant $V_D$. La grille $G_c$ est realiée à un potentiel constant $V_{DD}$ supérieur à $V_D$. Un interrupteur MOS $I_1$, situé dans le même plan que l'interrupteur $I_2$, sépare la grille $G_c$ de la première capacité de stockage $C_1$ selon le sens du transfert des charges indiqué par une flèche.

La capacité $C_1$ est connectée au point commun de deux transistors MOS $T_1$ et $T_2$ montés en série et reliés respectivement au signal electrique d'entrée E et à la tension $V_g$. La capacité $C_2$ est connectée en permanence à la tension $V_g$ qui est généralement de l'ordre de 5 V. Les moyens qui convertissent les charges en tension électrique comportent une capacité de lecture des charges $C_l$, située dans le même plan que les capacités $C_1$ et $C_2$, et séparée de la capacité $C_2$ par un interrupteur MOS $I_3$, situé dans le même plan que les interrupteurs $I_1$ et $I_2$. Ces moyens comportent également un circuit R, relié au point P à la capacité $C_l$ et qui fournit au point S la tension de sortie. Un transistor MOS $T_3$ est connecté entre le point P et la masse.

Après la capacité de lecture $C_l$, le potentiel de surface du substrat est fixé à zéro par un interrupteur MOS $I_4$, suivi par une zone de type P+ fortement dopée et de même conductivité que le substrat, qui est implantée sous la surface du substrat, l'interrupteur $I_4$ et la zone de type $P^+$ sont portés au même potentiel de référence que le substrat.

Les figures 2b, c, d, e, f, illustrent le procédé de filtrage selon l'invention et vont nous permettre de décrire le fonctionnement du filtre de la figure 2a. Sur ces figures, on a représenté l'état des puits de potentiels créés dans le substrat 1 à divers instants $t_1$ à $t_5$ et pour des raisons de clarté, on a seulement représenté l'interface 13 du substrat avec la première couche isolante 11.

Il est par ailleurs à noter que dans toute la description le substrat semi-conducteur est de type P et que les charges transférées sont des porteurs minoritaires (électrons). Il est bien entendu, que pour un substrat de type N, où ce sont les trous qui se déplacent, il suffit d'inverser la polarité de tous les potentiels appliqués.

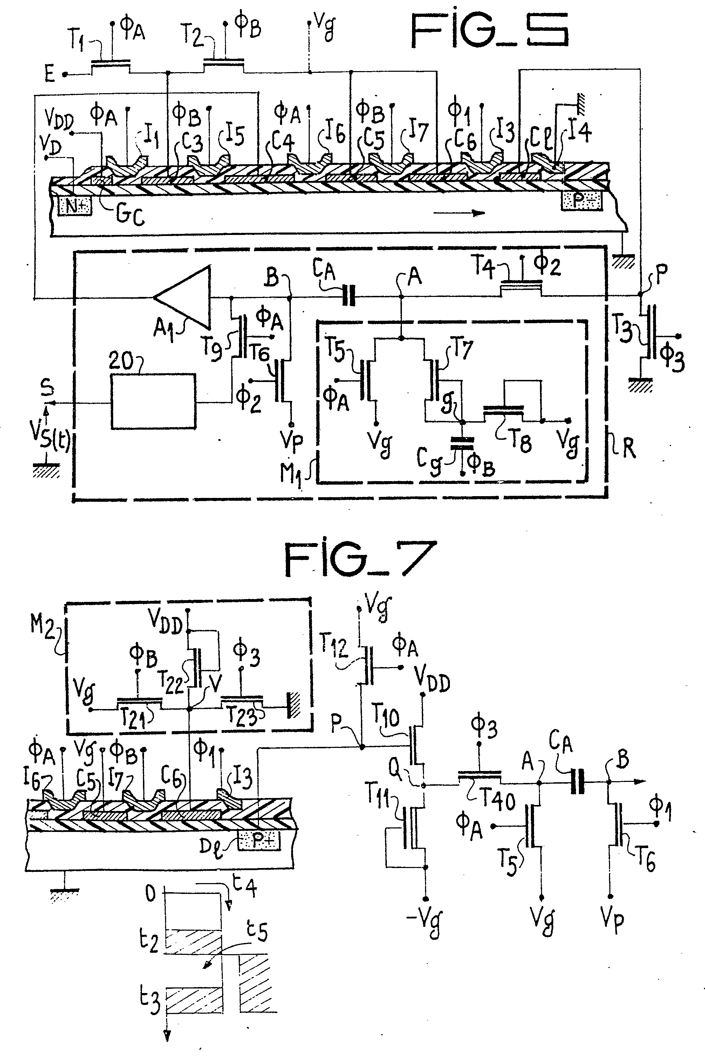

La figure 3 représente des diagrammes de signaux susceptibles d'être appliqués au filtre de la figure 2a. Les figures 3a, b, c, représentent des potentiels $\phi_A$, $\phi_B$, $\phi_L$ appliqués à l'interrupteur $I_1$ et au transistor $T_3$ pour $\phi_A$, à l'interrupteur $I_2$, et au transistor $T_2$ pour $\phi_B$, à l'interrupteur $I_3$ et au transistor $T_1$ pour $\phi_L$. Les potentiels $\phi_A$, $\phi_B$, $\phi_L$, sont des fonctions périodiques de même période T et du type en créneaux dont l'amplitude varie entre un niveau bas et un niveau haut. Les potentiels $\phi_A$ et $\phi_B$ sont de préférence identiques mais déphasés de façon à ne pas être simultanément au niveau haut. Le potentiel $\phi_L$ passe au niveau haut avant $\phi_A$ mais alors que $\phi_B$ est au niveau bas, et passe au niveau bas en même temps que $\phi_A$.

La figure 2b, illustre l'étape a) du procédé au cours de laquelle on introduit sous la première capacité selon le sens de transfert des charges $C_1$, une quantité de charges correspondant à l'échantillon du signal électrique d'entrée E en cours de traitement.

L'interrupteur $I_1$, et le transistor $T_1$ sont alors conducteur, l'interrupteur $I_2$ et le transistor $T_2$ sont bloqués. Un même potentiel de surface égal à $V_D$, la tension de polarisation de la diode D, s'établit sous la grille de commande $G_c$ et sous la capacité $C_1$.

La figure 2b illustre également l'étape b) du procédé au cours de laquelle on introduit sous la dernière capacité selon le sens de transfert des charges, $C_2$, une quantité de charges égale à celle qui s'y trouvait lors du traitement de l'échantillon précédent du signal électrique d'entrée, avant que commence le transfert des charges de cette dernière capacité vers les moyens qui convertissent les charges en tension électrique.

3

**0012667**

Le transistor $T_3$ conduit et remet la capacité de lecture $C_1$ à zéro. L'interrupteur $I_3$ conduit aussi et la quantité de charges stockées sous $C_1$ est transférée sous $C_2$, qui est soumise au potentiel $V_g$.

Le filtre de la figure 2a se trouve dans l'état représenté sur la figure 2b au temps $t_1$ indiqué sur la figure 3, tel que $\phi_A$ et $\phi_L$ soient simultanément au niveau haut.

La figure 2c représente l'état du filtre de la figure 2a, au temps $t_2$, où tous les interrupteurs et transistors sont bloqués.

Le potentiel de surface sous la capacité $C_1$ au temps $t_2$, $\phi_{S1}(t_2)$, est sensiblement égal à sa valeur $V_D$ au temps $t_1$.

Dans une capacité MOS, la relation à un instant t entre la tension V appliquée à cette capacité, le potentiel de surface $\phi_S$ et la charge d'inversion Q sous la capacité, s'écrit:

$$V(t) = \phi_s(t) + 2\sqrt{V_o\phi_s(t)} + \frac{Q(t)}{C}$$

avec C, valeur de la capacité et

$$V_{-o} = \frac{\varepsilon s.^{q.N}A}{C^2}$$

où $\varepsilon_S$ est la constante diélectrique du semi-conducteur, q la charge de l'électron et $N_A$ la densité d'ions accepteurs dans le semi-conducteur.

Au temps $t_2$, les charges d'inversion sous les capacités $C_1$ et $C_2$ s'écrivent:

$$(1) \quad \begin{cases} Q_1(t_2) = C_1 \left(E(t_2) - V_D - \sqrt{2 V_0 V_D}\right) = C_1 \cdot \gamma_1(t_2) \\ Q_2(t_2) = C_2 \left(V_g - \phi_{S2}(t_2) - \sqrt{2 V_0 \phi_{S2}(t_2)}\right) = C_2\gamma_2(t_2) \\ \text{avec } \gamma(t) = V(t) - \phi_s(t) - \sqrt{2 V_0 \phi_s(t)} \end{cases}$$

La figure 2d illustre l'étape c) du procédé au cours de laquelle on établit un potentiel de surface commun entre deux capacités successives, les capacités étant portées pendant cette étape au potentiel $V_g$.

L'interrupteur $I_2$ et le transistor $T_2$ sont alors conducteurs, les interrupteurs $I_1$ et $I_3$ et le transistor $T_1$ étant bloqués.

Le filtre se trouve dans l'état représenté sur la figure 2d au temps $t_3$, où seul le potentiel $\phi_B$ est au niveau haut.

La figure 2e réprésente l'état du filtre à l'instant où tous les potentiels $\phi_A$, $\phi_B$, $\phi_L$ sont au niveau bas.

Sous les capacités $C_1$ et $C_2$, s'établit sensiblement le même potentiel de surface $\phi_{S1}(t_4)$ et $\phi_{S2}(t_4)$, qui est sensiblement égal à $\phi_S(t_3)$, le potentiel de surface commun à $C_1$ et $C_2$ au temps $t_3$.

De $t_2$ à $t_4$, les capacités $C_1$ et $C_2$ sont isolées du reste du substrat semi-conducteur par les interrupteurs $I_1$ et $I_3$ qui sont bloqués. On peut donc écrire l'égalité suivante:

$$Q_1(t_4) + Q_2(t_4) = Q_1(t_2) + Q_2(t_2) \tag{2}$$

d'autre part:

$$\gamma_1(t_4) = \gamma_2(t_4) \tag{3}$$

car les capacités $C_1$ et $C_2$ reçoivent alors la même tension $V_g$ et ont sensiblement le même potentiel de surface. La répartition des charges entre les capacités $C_1$ et $C_2$ au temps $t_4$ dépend des valeurs de ces capacités.

A l'instant $t_4$, se trouve sous la capacité $C_2$ une quantité de charges qui va être transférée lors de l'étape suivante du procédé (étape d)) vers les moyens qui convertissent les charges en tension électrique, cette même quantité de charges sera présente à nouveau sous $C_2$, au temps $t_2$, lors du traitement de l'échantillon suivant du signal électrique d'entrée. On peut donc écrire que:

$$C_2 \gamma_2(t_2) = C_2 \gamma_2(t_4 - T) \tag{4}$$

Es égalités (2), (3), (4) nous permettent d'écrire que:

$$\gamma_2(t_4) (C_1 + C_2) = C_1 \gamma_1(t_2) + C_2 \gamma_2(t_4 - T)$$

4

En passant dans le domaine fréquentiel, on obtient:

$$H(\omega) = \frac{v_2(\omega)}{\gamma_1(\omega)} = \frac{(1-\beta)\, e^{-j\omega\tau}}{1 - \beta e^{-j\omega T}} \qquad (5)$$

avec

$$\beta = \frac{C_2}{C_1 + C_2} \quad \text{et } \tau = t_4 - t_2.$$

La figure 2f illustre l'étape du procédé dans laquelle on transfére les charges de la dernière capacité $C_2$ vers les moyens qui convertissent les charges en tension électrique, et en particulier sous la capacité de lecture $C_o$.

L'interrupteur $I_3$ est conducteur, l'interrupteur $I_2$ est alors bloqué.

Le filtre se trouve dans l'état représenté sur la figure 2f au temps $t_5$ où seul le potentiel $\phi L$ est au niveau haut.

Lors de l'étape d), le potentiel du point P est maintenu à une valeur constante par le circuit R, grâce à un prélèvement de charges sur une capacité $C_A$.

La variation de signal de sortie au point S est:

$$\Delta V_S = -\frac{\Delta Q}{C_A} = -\frac{Q_2(t_4)}{C_A}.$$

si on néglige la variation de charge d'espace.

En passant dans le domaine fréquentiel et en tenant compte des relations (1) et (5) on obtient:

$$\Delta V_S(\omega) = -\frac{C_2}{C_A} H(\omega)\, E(\omega)$$

La fonction de transfert du filtre de la figure 2a s'écrit:

$$P(\omega) = -\frac{C_2}{C_A}.$$

$$\frac{(1-\beta)\, e^{-j\omega\tau}}{1 - \beta e^{-j\omega T}},$$

ce qui est bien la fonction de transfert du filtre de la figure 1, le gain g de l'amplificateur étant égal

à $-\dfrac{C_2}{C_A}$.

La fréquence de coupure du filtre selon l'invention se règle en agissant sur la valeur de $\beta$ et donc sur les valeurs des capacités $C_1$ et $C_2$, en modifiant par exemple les dimensions $L_1$ et $L_2$ de ces capacités. L'ordre des étapes a) et b) du procédé n'a pas d'importance, par contre ces étapes doivent être réalisés avant l'étape c) qui doit précéder l'étape d).

La figure 4 illustre le schéma d'un filtre à capacités commutées du dexième ordre selon l'art connu. Il s'agit d'une cellule de Sallen Key comportant deux résistances en série constituées par les interrupteurs $I_1$ et $I_5$ et la capacité $C_3$ pour la première et les interrupteurs MOS $I_6$ et $I_7$ et la capacité $C_5$ pour la deuxième. Une capacité $C_6$ est connectée entre l'une des bornes de la deuxième résistance et la masse, cette borne étant reliée à l'entrée d'un amplificateur de gain g dont la sortie est renvoyée par l'intermédiaire d'une capacité $C_4$ au point commun des deux résistances.

La figure 5 représente un mode de réalisation selon l'invention du filtre de la figure 4. On a représenté, vu en coupe, parallèlement au sens de transfert des charges indiqué par une flèche, le réseau de capacités et d'interrupteurs du filtre de la figure 4, on a également représenté sur la figure 5 le schéma du circuit électrique associé à ce réseau.

Le filtre représenté sur la figure 5 se distingue de celui représenté sur la figure 2a car il comporte non plus deux, mais quatre capacités de stockage $C_3$, $C_4$, $C_5$, $C_6$, séparées par des interrupteurs MOS $I_5$, $I_6$, $I_7$.

Les armatures des capacités $C_5$, $C_6$ étant reliées à $V_g$, la capacité $C_4$ qui sert au bouclage du filtre,

**0012667**

reçoit pendant l'étape e) du procédé une tension égale à $V_g + \Delta V_s$ où $\Delta V_s$ est la variation de la tension de sortie du filtre pour l'échantillon précédent du signal électrique d'entrée. Pendant l'étape e), un potentiel de surface commun est établi entre la capacité $C_4$ et la capacité suivante $C_5$, qui est portée au potentiel $V_g$. La capacité $C_4$ reçoit le potentiel $V_g + \Delta V_s$ d'un point B situé à l'intérieur du circuit R appartenant aux moyens qui convertissent les charges en tension électrique et dont le schéma électrique sera décrit en détail dans ce qui suit. Ce circuit R diffère donc de celui utilisé pour le filtre de la figure 2 qui n'est pas bouclé.

L'ordre des étapes a), b), et e) du procédé n'a pas d'importance, par contre les étapes a), b) et e) doivent être réalisées, avant l'étape c), qui doit précéder l'étape d).

Le circuit R comporte un transistor MOS $T_4$ en série avec l'une des bornes d'une capacité $C_A$. Au point A de connection du transistor $T_4$ et de la capacité $C_A$ est relié un circuit de commande $M_1$. L'autre borne de la capacité $C_A$ est reliée à un point B, un transistor MOS $T_6$ est connecté entre le point B et un potentiel fixe $V_p$. Le point B est relié à la capacité $C_4$ qui assure le bouclage du filtre, par l'intermediaire, d'un étage suiveur ou d'un amplificateur de gain unité $A_1$. Entre le point B et une point S, on peut relier un transistor $T_9$ commandé par $\phi_A$ et un étage de sortie 20, qui assure le blocage et le maintien de la tension de sortie en S.

Le circuit de commande $M_1$ comporte un transistor $T_5$ entre le point A et le potentiel $V_g$ et un transistor $T_7$ entre le point A et un point g; au point g sont également reliés la grille de $T_7$, une capacité $C_g$ et un transistor $T_8$ dont les deux autres bornes sont portées à $V_g$.

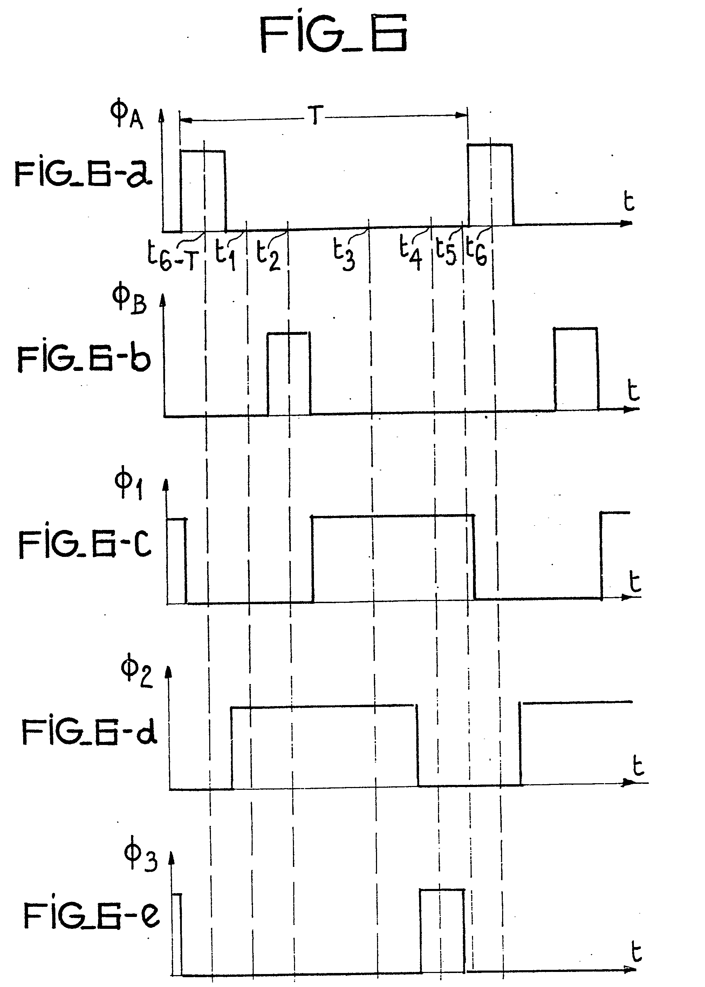

La figure 6 représente des diagrammes de signeaux susceptibles d'être appliqués au filtre de la figure 5. Les figures 6a, b, c, d, e, représentent des potentiels $\phi_A$, $\phi_B$, $\phi_1$, $\phi_2$, $\phi_3$ appliqués aux interrupteurs $I_1$ et $I_6$ et aux transistors $T_1$, $T_5$ et $T_9$ pour $\phi_A$, aux interrupteurs $I_5$, $I_7$, au transistor $T_2$ et à la capacité $C_g$ pour $\phi_B$, à l'interrupteur $I_3$ pour $\phi_1$, aux transistors $T_4$ et $T_6$ pour $\phi_2$ et enfin au transistor $T_3$ pour $\phi_3$.

Comme les potentiels représentés sur la figure 3, les potentiels $\phi_A$, $\phi_B$, $\phi_1$, $\phi_2$, $\phi_3$ sont des fonctions périodiques, de même période T, et du type en créaux, dont l'amplitude varie entre un niveau bas et un niveau haut. Les potentiels $\phi_A$ et $\phi_B$ sont de préférence identiques mais déphasés de façon à ne pas être simultanément conducteurs. Le potentiel $\phi_1$ passe au niveau haut, lorsque $\phi_B$ est au niveau bas et dans l'exemple donné sur la figure 6, $\phi_1$ est au niveau haut pendant l'intervalle de temps où $\phi_A$ et $\phi_B$ sont au niveau bas. Le potentiel $\phi_2$ passe au niveau haut lorsque $\phi_A$ est au niveau bas et passe au niveau bas, alors que $\phi_1$ est toujours au niveau haut. Le potentiel $\phi_3$ passe au niveau haut alors que $\phi_2$ est au niveau bas et que $\phi_1$ est au niveau haut et passe au niveau bas avant ou en même temps que $\phi_1$.

Au temps $t_1$, indiqué sur la figure 6, $\phi_2$ est au niveau haut. Le transistor $T_4$ fonctionne en triode établissant le même potentiel sur les points A et P. Le point B est porté à un potentiel $V_p$ par le transistor $T_6$.

Au temps $t_2$, $\phi_B$ et $\phi_2$ sont au niveau haut. L'étape c) du procédé se déroule. Le transistor $T_6$ conduit et la tension au point B égale $V_p$. On doit choisir $V_p = V_g$ afin que la capacité $C_4$ soit portée au potentiel $V_g$ pendant l'étape c). La capacité $C_g$ transmet au point g l'excursion en tension $V_{\phi B}$ du potentiel $\phi_B$. Le point g passe ainsi de $V_g - V_{T8}$ à $V_g - V_{T8} + V_{\phi B}$, où $V_{T8}$ est la tension de seuil de $T_8$. Le transistor $T_7$ se met à conduire et charge les capacités $C_A$ et $C_I$, à condition que $C_g \gg C_A + CI$, jusqu'au moment où le transistor $T_4$ est en saturation, fixant ainsi le potentiel du point P à $V_{\phi 2} - V_{T4}$, où $V_{\phi 2}$ correspond au niveau haut du potentiel $\phi_2$ et où $V_{T4}$ est la tension du seuil de $T_4$, qui est négative car $T_4$ est un transistor MOS à déplétion, alors que les autres transistors du circuit sont des transistors à enrichissement dont les tension de seuil $V_T$ sont positives. Le point A est au potentiel.

$$V_{AO} = V_g + V_{\phi B} - V_{T8} - V_{T7}.$$

Au temps $t_3$, $\phi_1$ et $\phi_2$ sont au niveau haut, l'étape d) du procédé se déroule. La quantité de charges présente sous la dernière capacité $C_6$ selon le sens de transfert des charges s'écoule sous la capacité de lecture $C_I$. Le potentiel du point P est maintenu constant par $T_4$ grâce à un apport de charges prélevé sur la capacité $C_A$, le transistor $T_7$ est bloqué depuis le passage de $\phi_B$ au niveau bas.

Le potentiel en A devient:

$$V_A = V_{AO} - \frac{Q_6(t_3)}{C_A} = V_{AO} - \Delta V_s, \text{ avec } \Delta V_s = -\frac{C_6}{C_A}H(\omega) \cdot E(\omega)$$

comme précédemment, $E(\omega)$ étant le signal présent à l'entrée du filtre et $H(\omega)$ étant la fonction de transfert du filtre du second ordre obtenue par la commutation des capacités $C_3$, $C_4$, $C_5$, $C_6$. La forme de cette fonction de transfert est fixée par les valeurs des capacités $C_3$, $C_4$, $C_5$, $C_6$ et la valeur du gain de boucle

$$g = \frac{-C_6}{C_A}.$$

6

Le traitement d'un nouvel échantillon du signal électrique d'entrée commence ensuite.

Au temps $t_4$, $\phi_1$ et $\phi_3$ sont au niveau haut. L'étape b) du procédé se déroule. Le retour au niveau bas de $\phi_2$ provoque le blocage de $T_6$ et de $T_4$, le point B devient flottant, les points A et P sont isolés et le point P est relié au potentiel de référence par $T_3$, la quantité de charges $Q_6$ ($t_3$) est restituée par la capacité de lecture $C_1$ sous la dernière capacité $C_6$.

Au temps $t_6$, $\phi_A$ est au niveau haut. Les étapes a) et e) du procédé se déroulent. Le potentiel du point A est porté à $V_g$. Le potentiel du point B devient:

$$V_B = V_g + V_p - V_A = V_g + V_p - V_{AO} + \Delta V_s.$$

Il faut choisir $V_p$ égal à $V_{AO}$ pour obtenir au point B une tension égale à $V_g + \Delta V_s$ où $\Delta V_s$ est la variation de la tension de sortie du filtre pour l'échantillon précédent du signal électrique. Le transistor $T_9$ conduit et transmet la tension $V_g + \Delta V_s$ à la capacité $C_4$. Le gain g de l'amplificateur du schéma de la figure 4 est égal

$$\text{à} - \frac{C_6}{C_A}.$$

Le signale de sortie est également disponible au point S.

La figure 7 représente un autre mode de réalisation selon l'invention du filtre de la figure 4 auquel peuvent s'appliquer les signaux représentés sur la figure 6.

Ce mode de réalisation diffère de celui de la figure 5 car le dernière capacité $C_6$ n'est pas connectée en permanence au potential $V_g$. Sur la figure 7, la capacité $C_6$ est connectée à un circuit de commande $M_2$ qui permet de la porter au potentiel $V_{DD}$ pendant l'étape b) du procédé, au potentiel $V_g$ pendant l'étape c) et au potentiel de référence pendant l'étape d). Le circuit $M_2$ comporte trois transistors reliés à la capacité $C_6$ en un point V, et reliés d'autre part à la tension $V_g$ pour le transistor $T_{21}$, à la tension $V_{DD}$ pour le transistor $T_{22}$, dont la grille est également portée à $V_{DD}$, et à la tension de référence pour le transistor $T_{23}$. Ce mode de réalisation diffère également de celui de la figure 5 par les moyens qui convertissent les charges en tension électrique. Ces moyens comportent une diode de lecture intégrée dans le substrat semi-conducteur et séparée de la dernière capacité $C_6$ par un interrupteur $I_3$. La diode $D_l$ est reliée à un point P, où sont connectés un transistor $T_{12}$, qui est également connecté à la tension $V_g$ et un étage de gain k qui peut être un étage suiveur, constitué par un transistor $T_{10}$, dont la grille est reliée au point P et connecté entre la tension $V_{DD}$ et un point Q, et par un transistor MOS à déplétion $T_{11}$ entre le point Q, et la tension $-V_g$, la grille de $T_{11}$ est également reliée à $-V_g$. Entre le point Q et un point B, un transistor $T_{40}$ est placé en série avec l'une des bornes d'une capacité $C_A$ dont l'autre borne est reliée à un point B. Entre le point commun A, de $T_{40}$ et de $C_A$, est placé un transistor $T_5$ qui est également relié à $V_g$. Entre le point B et le potentiel $V_p$ est connecté un transistor $T_6$. A partir du point B, le schéma du circuit est identique à celui du mode de réalisation représenté sur la figure 5.

Par rapport au mode de réalisation de la figure 5, le potentiel $\phi_A$ est appliqué également au transistor $T_{12}$, le potentiel $\phi_B$ au transistor $T_{21}$, le potentiel $\phi_1$ au transistor $T_6$ et le potentiel $\phi_3$ aux transistors $T_{23}$ et $T_{40}$.

Au temps $t_2$, l'étape c) du procédé se déroule. Le transistor $T_{21}$ conduit et porte la dernière capacité $C_6$ au potentiel $V_g$.

Au temps $t_3$, la dernière capacité $C_6$ est portée au potentiel $V_{DD}$, de l'ordre de 12 V, par le transistor $T_{22}$. L'interrupteur $I_3$ reçoit le niveau haut du potentiel $\phi_1$, qui égale $V_g$, de l'ordre 5 V. Le niveau bas de $\phi_1$ est pris égal au potentiel de référence.

Le niveau des potentiels sous $C_6$ est plus élevé que le niveau des potentiels sous l'interrupteur $I_3$ comme cela est schématisé sur la figure 7, qui représente l'état des puits de potentiels sous $C_6$, $I_3$ et $D_l$ aux temps $t_2$, $t_3$, $t_4$, $t_5$. Au temps $t_3$, le transfert des charges de $C_6$ vers $D_l$ ne peut donc s'effectuer. Au temps $t_3$, le point B est porté à un potentiel $V_p$ par le transistor $T_6$.

Au temps $t_4$, l'étape d) du procédé se déroule. La capacité $C_6$ est portée au potentiel de référence par le transistor $T_{23}$, il faut pour cela que $T_{23}$ soit beaucoup plus conducteur que $T_{22}$. Il y a transfert des charges de $C_6$ sous la diode $D_l$ dont le potentiel a été restauré à $V_g$ au temps $t_6 - T$ indiqué sur la figure 6. Le transistor $T_{40}$ conduit et la capacité $C_A$ se charge. L'excursion de tension en A égale:

$$V_A = V_A - V_{AO} = -k\frac{Q_6}{C_D}$$

où k est le gain du suiveur, $Q_6$ la quantité de charges présente sous $C_6$ au temps $t_3$ et $C_D$ la capacité au point P. L'étage suiveur peut être remplacé par un amplificateur de gain k égal à 1.

Au temps $t_5$, commence le traitement d'un nouvel échantillon du signal d'entrée. L'étape b) du procédé se déroule. Le potentiel $\phi_3$ est au niveau bas, le transistor $T_{40}$ isole les points A et Q et le transistor $T_{22}$ porte la capacité $C_6$ au potentiel $V_{DD}$. Il y a transfert de la quantité de charges $Q_6$ de $D_l$ sous $C_6$.

**0 012 667**

Au temps $t_6$, les étapes a) et e) du procédé se déroulent. Le point A est porté au potentiel $V_g$ par $T_5$ et le potentiel du point B devient:

$$V_B = V_g + V_p - V_A = V_g + V_p + k\frac{Q_6}{C_D} - V_{AO}$$

Il suffit donc de choisir le potentiel $V_p$ égal à $V_{AO}$, pour obtenir

$$V_B = V_g + k\frac{Q_6}{C_D} = V_g + \Delta V_{S'}$$

où $\Delta V_S$ est la variation de la tension de sortie du filtre pour l'échantillon précédent du signal électrique d'entrée. Au temps $t_6$, la diode $D_I$ est restaurée au potentiel $V_g$ par $T_{12}$. Le gain g égale alors.

$$-k\frac{C_6}{C_D}.$$

Tous les transistors utilisés dans l'invention sont préférentiellement des transistors MOS à enrichissement, exceptés les transistors $T_{11}$ et $T_4$ qui sont des transistors MOS à déplétion.

**Revendications**

1. Procédé de filtrage d'un signal électrique par transfert de charges dans un substrat semi-conducteur, ce substrat étant recouvert d'une première couche isolante, sur laquelle est disposée une première série d'électrodes, qui constituent avec la première couche isolante et le substrat des capacités de stockage des charges, une deuxième série d'électrodes étant intercalées avec la première dont elle est séparée par une deuxième couche isolante, les électrodes de cette deuxième série constituant avec la première et la deuxième couche isolante et avec le substrat des interrupteurs qui commandent le transfert des charges entre les capacités de stockage, ce procédé étant caractérisé, lors du traitement de chaque échantillon du signal électrique d'dentrée, par les étapes suivantes:

a) introduction sous la première capacité ($C_3$), selon le sens de transfert des charges d'une quantité de charges correspondant à l'échantillon du signal électrique d'entrée en cours de traitement;
b) introduction sous la dernière capacité ($C_6$), selon le sens de transfert des charges, d'une quantité de charges égale à celle qui s'y trouvait, lors du traitement de l'échantillon précédent du signal électrique d'entrée, avant que commence le transfert des charges de cette dernière capacité vers des moyens qui convertissent les charges en tension électrique;
c) établissement d'un potentiel de surface commun entre deux capacités successives, les capacités étant portées pendant cette étape à un potentiel constant $V_g$;
d) transfert des charges de la dernière capacité, selon le sens de transfert des charges, vers des moyens qui convertissent les charges en tension électrique; l'ordre des étape a) et b) du procédé étant quelconque, par contre les étapes a) et b) précédant l'étape c) qui précède l'étape d).

2. Procédé de filtrage selon la revendication 1, caractérisé en ce qu'il comporte, lors du traitement de chaque échantillon du signai électrique d'entrée, une étape e) supplémentaire au cours de laquelle un potentiel de surface commun est établi entre l'une des capacités de stockage des charges ($C_4$), qui assure le bouclage du filtre, et la capacité suivante, selon le sens de transfert des charges, ces capacités étant respectivement portées pendant cette étape à des tensions $V_g + \Delta V_S$ et $V_{g'}$ où $\Delta V_S$ est la variation de la tension de sortie du filtre pour l'échantillon précédent du signal électrique d'entrée, l'ordre des étapes a), b) et e) du procédé étant quelconque, par contre les étapes a), b) et e) précédant l'étape c), qui précède l'étape d).

3. Filtre à capacités commutées utilisant un procédé de filtrage selon l'une des revendications 1 ou 2, caracterisé en ce qu'il comporte une diode (D), implantée dans le substrat semi-conducteur (1) et portée à un potentiel constant $V_D$, et une grille ($G_C$), située dans le même plan que les capacités de stockage ($C_3$, $C_4$, $C_5$, $C_6$) et portée à un potentiel constant $V_{DD}$ supérieur à $V_D$, qui commande le courant délivré par la diode, la grille étant séparée de la première capacité, selon le sens de transfert des charges, par un interrupteur $I_1$, situé dans le même plan que les autres interrupteurs ($I_5$, $I_6$, $I_7$) et la première capacité étant reliée au point commun de deux transistors $T_1$ et $T_2$, montés en série, et reliés respectivement au signal électrique d'entrée E et à la tension $V_{g'}$ les transistors $T_1$ et $T_2$ et l'interrupteur $I_1$ étant soumis à des potentiels périodiques ($\phi_A$, $\phi_B$) tels que, pendant l'étape a) du procédé, le transistor $T_1$ conduise et l'interrupteur $I_1$ soit fermé et pendant l'étape c), le transistor $T_2$ conduise.

4. Filtre à capacités commutées selon la revendication 3, caractérisé en ce que les moyens qui

8

# 0012667

convertissent les charges en tension électrique comportent une capacité de lecture des charges $C_l$, située dans le même plan que les autres capacités de stockage et séparée de la dernière capacité de stockage ($C_6$) selon le sens de transfert des charges, par un interrupteur $I_3$, situé dans le même plan que les autres interrupteurs, le potentiel de surface du substrat étant fixé a zéro après la capacité de lecture par un interrupteur $I_4$, situé dans le même plan que les autres interrupteurs, suivi par une zone, de même conductivité que le substrat mais fortement dopée qui est implantée sous la surface du substrat, l'interrupteur $I_4$ et la zone fortement dopée étant portés au potentiel de référence du substrat, et caractérisé en ce que la capacité de lecture est reliée au point P à un circuit R, qui. maintient, lors de l'étape d) du procédé, le point P à un potentiel constant en prélevant des charges sur une capacité $C_A$, et fournit la tension de sortie $V_s(t)$ du filtre.

5. Filtre selon la revendication 4, caractérisé en ce que le circuit R comporte, relié au point P, un transistor $T_4$ en série avec l'une des bornes de la capacité $C_A$, un circuit de commande $M_1$ étant relié au point commun A du transistor et de la capacité et un transistor $T_6$ étant connecté entre l'autre borne de la capacité, point B, et une potentiel fixe $V_p$ et en ce que les transistors $T_4$ et $T_6$ et le circuit de commande $M_1$ sont soumis à des potentiels périodiques ($\phi_2$, $\phi_A$, $\phi_B$) tels que successivement:

— le point B est porté au potentiel $V_p$ par le transistor $T_6$;
— le circuit de commande $M_1$ assure la charge de la capacité $C_A$ et de la capacité de lecture $C_l$, à travers le transistor $T_4$, puis la saturation du transistor $T_4$;
— au cours de l'étape d) du procédé, le transistor $T_4$ en saturation maintient un potentiel constant au point P en prélevant des charges sur la capacité $C_A$ et le potentiel du point A initialement à $V_{AO}$ diminue;
— le blocage des transistors $T_6$ et $T_4$ rend le potentiel au point B flottant et isole les points A et P;
— au cours de l'étape e) du procédé, le point A est porté au potentiel $V_g$ par le circuit de commande $M_1$ et le potentiele au point B est, les potentiels $V_p$ et $V_{AO}$ étant égaux, $V_g + \Delta V_s$, où $\Delta V_s$ est la variation de la tension de sortie du filtre pour l'échantillon précédent du signal électrique d'entrée, ce potentiel $V_g + \Delta V_s$ étant appliqué à la capacité ($C_4$) qui assure le bouclage du filtre.

6. Filtre selon la revendication 5, caractérisé en ce que le circuit de commande $M_1$ comporte un transistor $T_5$ entre le point A et le potentiel fixe $V_g$ et un transistor $T_7$ entre le point A et un point g, la grille de $T_7$ étant connectée au point g, de même qu'une capacité $C_g$ et un transistor $T_8$, dont les deux autres bornes sont portées au potentiel $V_g$, la grille de $T_5$ et la capacité $C_g$ recevant périodiquement des potentials donnés ($\phi_A$, $\phi_B$).

7. Filtre selon l'une des revendications 4, 5 ou 6, caractérisé en ce qu'un transistor $T_3$ est connecté entre le point P et la tension de référence, ce transistor $T_3$ recevant périodiquement sur sa grille un potentiel donné ($\phi_3$) qui provoque le déroulement de l'étape b) du procédé.

8. Filtre selon la revendication 3, caractérisé en ce que la dernière capacité de stockage, selon le sens de transfert des charges ($C_6$) est connectée à un circuit de commande $M_2$, et en ce que les moyens qui convertissent les charges en tension électrique comportent une diode de lecture $D_l$ intégrée dans le substrat semi-conducteur de séparée de la dernière capacité par un interrupteur $I_3$, situé dans le même plan que les autres interrupteurs, la diode $D_l$ étant reliée à un point P où sont connectés un transistor $T_{12}$, entre le point P et le potentiel $V_g$ et un étage de gain k, entre le point P et un point Q, un transistor $T_{40}$ étant placé en série avec l'une des bornes d'une capacité $C_A$, entre le point Q et un point B, un transistor $T_5$ étant connecté entre le point commun A de $T_{40}$ et $C_A$ et le potentiel $V_g$ et un transistor $T_6$ étant connecté entre le point B et le potentiel $V_p$, le circuit de commande $M_2$, l'interrupteur $I_3$ et les transistors $T_{40}$, $T_5$, $T_6$ étant soumis à des potentiels périodiques ($\phi_A$, $\phi_B$, $\phi_1$, $\phi_3$) tels que successivement:

— le circuit de commande $M_2$ porte la dernière capacité au potentiel $V_g$ et l'étape c) du procédé se déroule;
— le circuit de commande $M_2$ porte la dernière capacité au potentiel $V_{DD}$, l'interrupteur $I_3$ est porté au potentiel $V_g$, et le point B est porté au potentiel $V_p$ par le transistor $T_6$;
— le circuit de commande $M_2$ porte la dernière capacité au potentiel de référence, l'étape d) du procédé se déroule et le potentiel en A initialement à $V_{AO}$ évolue;
— le blocage du transistor $T_{40}$ isole les points A et Q le circuit de commande $M_2$ porte la dernière capacité au potentiel $V_{DD}$ et l'étape b) du procédé se déroule;
— les étapes a) et e) du procédé se déroulent, le point A est porté au potentiel $V_g$ par le transistor $T_5$, le potentiel du point B égale, les potentiels $V_p$ et $V_{AO}$ étant égaux, $V_g + \Delta V_s$, où $\Delta V_s$ est la variation de la tension de sortie du filtre pour l'échantillon précédent du signal électrique d'entrée, ce potentiel $V_g + \Delta V_s$ étant appliqué à la capacité ($C_4$) qui assure le bouclage du filtre, et enfin la diode $D_l$ est restaurée au potentiel $V_g$ par le transistor $T_{12}$.

9. Filtre selon la revendication 8, caractérisé en ce que le circuit de commande $M_2$ comporte trois transistors reliés d'une part à la dernière capacité $C_6$ en un point V et d'autre par au potentiel $V_g$ pour le transistor $T_{21}$, au potentiel $V_{DD}$ pour $T_{22}$, dont la grille est relié à $V_{DD}$, et au potentiel de référence pour $T_{23}$, les transistors $T_{21}$ et $T_{23}$ recevant périodiquement sur leurs grilles des potentiels donnés ($\phi_B$, $\phi_3$).

10. Filtre selon l'une des revendications 3 à 9, caractérisé en ce que les transistors sont du type MOS.

11. Filtre selon la revendication 5, caractérisé en ce que le transistor $T_4$ est du type MOS à déplétion.

**Patentansprüche**

1. Verfahren zum Filtern eines elektrischen Signals durch Ladungsüberführung in einem Halbleitersubstrat, wobei dieses Substrat von einer ersten isolierenden Schicht bedeckt ist, auf der eine erste Reihe von Elektroden angeordnet ist, die mit der ersten isolierenden Schicht und dem Substrat Ladungsspeicherkapazitäten bilden, wobei eine zweite Reihe von Elektroden mit der ersten verschachtelt ist, von der sie durch eine zweite Isolierschicht getrennt ist, wobei die Elektroden dieser zweiten Reihe mit der ersten und der zweiten Isolierschicht sowie mit dem Substrat Unterbrecher bilden, welche die Ladungsüberführung zwischen den Speicherkapazitäten steuern, und wobei dieses Verfahren durch die folgenden Stufen bei der Verarbeitung jeder Abtastprobe des elektrischen Eingangssignals gekennzeichnet ist:

a) Unter die erste Kapazität ($C_3$) in Richtung der Ladungsüberführung wird eine Ladungsmenge eingeleitet, die der gerade in der Verarbeitung befindlichen Abtastprobe des elektrischen Eingangssignals entspricht;

b) unter die letzte Kapazität ($C_6$) in Richtung der Ladungsüberführung wird eine Ladungsmenge eingeleitet, die gleich derjenigen ist, welche sich bei der Verarbeitung der vorausgehenden Abtastprobe des elektrischen Eingangssignals dort befand, bevor die Überführung der Ladungen dieser letzteren Kapazität zu den Mitteln beginnt, welche die Ladungen in eine elektrische Spannung umsetzen;

c) Aufbau eines gemeinsamen Oberflächenpotentials zwischen zwei aufeinanderfolgenden Kapazitäten, wobei die Kapazitäten während dieser Stufe auf ein konstantes Potential ($V_g$) gebracht werden;

d) die Ladungen der letzten Kapazität werden in Richtung der Ladungsüberführung zu den Mitteln überführt, welche die Ladungen in eine elektrische Spannung umsetzen;

wobei die Reihenfolge der Stufen a) und b) des Verfahrens beliebig ist, hingegen die Stufen a) und b) der stufe c) vorausgehen, welche der Stufe d) vorausgeht.

2. Verfahren zum Filtern nach Anspruch 1, dadurch gekennzeichnet, daß es während der Verarbeitung jeder Abtastprobe des elektrischen Eingangssignals eine zusätzliche Stufe e) umfaßt, während welcher ein gemeinsames Oberflächenpotential zwischen einer der Ladungsspeicherkapazitäten ($C_4$), welche die Schlaufenschaltung des Filters gewährleistet, und der in Richtung der Ladungsüberführung darauffolgenden Kapazität aufgebaut wird, wobei diese Kapazitäten während dieser Stufe auf die Spannungen $V_g + \Delta V_S$ bzw. $V_g$ gebracht werden, worin $\Delta V_S$ die Spannungsänderung am Ausgang des Filters für die vorausgehende Abtastprobe des elektrischen Eingangssignals ist, und wobei die Reihenfolge der Stufen a), b) und e) des Verfahrens beliebig ist, während die Stufen a), b) und e) der Stufe c) vorausgehen, welche der Stufe d) vorausgeht.

3. Filter mit geschalteten Kapazitäten, bei dem ein Filterverfahren nach Anspruch 1 oder 2 angewandt wird, dadurch gekennzeichnet, daß es eine in das Halbleitersubstrat (1) implantierte, auf ein konstantes Potential $V_D$ gebrachte Diode (D) und eine Steuerelektrode ($G_c$) umfaßt, die in derselben Ebene liegt wie die Speicherkapazitäten ($C_3$, $C_4$, $C_5$, $C_6$), auf ein konstantes $V_D$ überschreitendes Potential $V_{DD}$ gelegt ist und den von der Diode abgegebenen Strom steuert, wobei die Steuerelektrode von der ersten Kapazität in Richtung der Ladungsüberführung durch einen Unterbrecher $I_1$ getrennt ist, der in derselben Ebene liegt wie die anderen Unterbrecher ($I_5$, $I_6$, $I_7$), wobei die erste Kapazität mit dem gemeinsamen Punkt der beiden in Reihe geschalteten Transistoren $T_1$ und $T_2$ verbunden ist, welche mit dem elektrischen Eingangssignal E bzw. mit der Spannung $V_g$ sind, und wobei die Transistoren $T_1$ und $T_2$ sowie der Unterbrecher $I_1$ periodischen Potentialen ($\phi_A$, $\phi_B$) ausgesetzt sind, die derart sind, saß während der Stufe a) des Verfahrens der Transistor $T_1$ leitet und der Unterbrecher $I_1$ geschlossen ist und während der Stufe c) der Transistor $T_2$ leitet.

4. Filter mit geschalteten Kapazitäten nach Anspruch 3, dadurch gekennzeichnet, daß die Mittel, welche die Ladungen in eine elektrische Spannung umsetzen, eine Kapazität $C_l$ zum Lesen der Ladungen Umfaßt, welche in derselben Ebene liegt wie die anderen Speicherkapazitäten und von der letzten Speicherkapazität ($C_6$) in Richtung der Ladungsüberführung durch einen Unterbrecher $I_3$ getrennt ist, der in derselben Ebene liegt wie die anderen Unterbrecher, wobei das Oberflächenpotential des Substrates hinter der Lesekapazität auf Null festgelegt ist durch einen Unterbrecher $I_4$, der in derselben Ebene liegt wie die anderen Unterbrecher und auf den eine Zone derselben Leitfähigkeit wie das Substrat, die jedoch stark dotiert ist, folgt, welche unter der Substratoberfläche implantiert ist, wobei der Unterbrecher $I_4$ und die stark dotierte Zone auf das Bezugspotential des Substrates gelegt sind, und dadurch gekennzeichnet, daß die Lesekapazität am Punkt P mit einer Schaltung R verbunden ist, die während der Stufe d) des Verfahrens den Punkt P auf einem konstanten Potential hält, indem sie Ladungen an einer Kapazität $C_A$ abnimmt, und welche die Ausgangsspannung $V_S$ (t) des Filters liefert.

5. Filter nach Anspruch 4, dadurch gekennzeichnet, daß die Schaltung R einen mit dem Punkt P

10

verbundenen, in Reihe mit einem der Anschlüsse der Kapazität $C_A$ geschalteten Transistor $T_4$ umfaßt, wobei eine Steuerschaltung $M_1$ mit dem gemeinsamen Punkt A des Transistors und der Kapazität verbunden ist und ein Transistor $T_6$ zwischen den anderen Anschluß der Kapazität, den Punkt B, und ein festes Potential $V_p$ geschaltet ist, und daß die Transistoren $T_4$ und $T_6$ und die Steuerschaltung $M_1$ periodischen Potentialen ($\phi_2$, $\phi_A$, $\phi_B$) ausgesetzt sind, die derart sind, daß nacheinander:

— der Punkt B durch den Transistor $T_6$ auf das Potential $V_p$ gebracht wird;
— die Steuerschaltung $M_1$ die Aufladung der Kapazität $C_A$ und der Lesekapazität $C_l$ über den Transistor $T_4$ und dann die Sättigung des Transistors $T_4$ gewährleistet;
— während der Stufe e) des Verfahrens der Transistor $T_4$ in Sättigung ist und kein konstantes Potential am Punkt P aufrechterhält, indem er Ladungen an der Kapazität $C_A$ entnimmt, und daß das anfangs auf $V_{AO}$ befindliche Potential des Punktes A abnimmt;
— die Sperrung der Transistoren $T_6$ und $T_4$ das Potential am Punkt B freischwebend macht und die Punkt A und P isoliert werden;
— während der Stufe e) des Verfahrens der Punkt A durch die Steuerschaltung $M_1$ auf das Potential $V_g$ gebracht wird und das Potential am Punkt B $V_g + \Delta V_S$ ist, wobei die Potentiale $V_p$ und $V_{AO}$ gleich sind und worin $\Delta V_S$ die Spannungsänderung am Ausgang des Filters für die vorausgehende Abtastrobe des elektrischen Eingangssignals ist, und wobei dieses Potential $V_g + \Delta V_S$ an diejenige Kapazität ($C_4$) angelegt ist, welche die Schlaufenschaltung des Filters gewährleistet.

6. Filter nach Anspruch 5, dadurch gekennzeichnet, daß die Steuerschaltung $M_1$ einen Transistor $T_5$ zwischen dem Punkt A und dem festen Potential $V_g$ und einem Transistor $T_7$ zwischen den Punkt A und einem Punkt g umfaßt, wobei die Steuerelektrode von $T_7$ mit dem Punkt g verbunden ist, ebenso wie eine Kapazität $C_g$ und ein Transistor $T_8$, dessen zwei andere Anschlüsse auf ein Potential $V_g$ gelegt sind, wobei die Steuerelektrode von $T_5$ und die Kapazität $C_g$ periodisch gegebene Potentiale ($\phi_A$, $\phi_B$) empfangen.

7. Filter nach einem der Ansprüche 4, 5 oder 6, dadurch gekennzeichnet, daß ein Transistor $T_3$ zwischen den Punkt P und die Bezugsspannung geschaltet ist, wobei dieser Transistor $T_3$ periodisch an seiner Steuerelektrode ein gegebenes Potential ($\phi_3$) emfängt, welches den Ablauf der Stufe b) des Verfahrens hervorruft.

8. Filter nach Anspruch 3, dadurch gekennzeichnet, daß die in Richtung der Ladungsüberführung letzte Speicherkapazität ($C_6$) mit einer Steuerschaltung ($M_2$) verbunden ist, und daß die Mittel, welche die Ladungen in eine elektrische Spannung umsetzen, eine in das Halbleitersubstrat integrierte, von der letzten Kapazität durch einen Unterbracher $l_3$ getrennte Lesediode $D_l$ umfassen, wobei der Unterbrecher $l_3$ in derselben Ebene liegt wie die anderen Unterbrecher, die Diode $D_l$ mit einem Punkt P verbunden ist, an welchen ein zwischen dem Punkt P und dem Potential $V_g$ liegender Transistor $T_{12}$ sowie eine zwischen dem Punkt P und einem Punkt Q liegende Stufe mit der Verstärkung k angeschlossen sind, wobei ein in Reihe mit einem der Anschlüsse einer Kapazität $C_A$ liegender Transistor $T_{40}$ zwischen den Punkt Q und einen Punkt B geschaltet ist, ein Transistor $T_5$ zwischen den gemeinsamen Punkt A von $T_{40}$ und $C_A$ und das Potential $V_g$ geschaltet ist, wobei ein Transistor $T_6$ zwischen den Punkt P und das Potential $V_p$ geschaltet ist und wobei die Steuerschaltung $M_2$, der Unterbrecher $l_3$ und die Transistoren $T_{40}$, $T_5$, $T_6$ periodischen Potentialen ($\phi_A$, $\phi_B$, $\phi_1$, $\phi_3$) ausgesetzt sind, die derart sind, daß nacheinander:
— die Steuerschaltung $M_2$ die letzte Kapazität auf das Potential $V_g$ bringt und die Stufe c) des Verfahrens abläuft;
— die Steuerschaltung $M_2$ die letzte Kapazität aud das Potential $V_{DD}$ bringt, der Unterbrecher $l_3$ auf das Potential $V_g$ gelegt wird und der Punkt B durch den Transistor $T_6$ auf das Potential $V_p$ gebracht wird;
— die Steuerschaltung $M_2$ die letzte Kapazität auf das Bezugspotential bringt, wobei die Stufe d) des Verfahrens abläuft und das sich anfangs auf $V_{AO}$ befindende Potential an A sich entwickelt;
— die Sperrung des Transistors $T_{40}$ die Punkte A und Q isoliert, die Steuerschaltung $M_2$ die letzte Kapazität auf das Potential $V_{DD}$ bringt und die Stufe b) des Verfahrens abläuft;
— die Stufen a) und e) des Verfahrens ablaufen, wobei der Punkt A durch den Transistor $T_5$ auf das Potential $V_g$ gebracht wird, das Potential des Punktes B gleich $V_g + \Delta V_S$ ist, wobei die Potentiale $V_p$ und $V_{AO}$ gleich sind und worin $\Delta V_S$ die Spannungsänderung am Ausgang des Filters für die vorausgehende Abtastprobe des elektrischen Eingangssignals ist, wobei ferner das Potential $V_g + \Delta V_S$ an diejenige Kapazität ($C_4$) angelegt wird, die die Schleifenschaltung des Filters gewährleistet, und wobei schließlich die Diode $D_l$ durch den Transistor $T_{12}$ wieder auf das Potential $V_g$ gebracht wird.

9. Filter nach Anspruch 8, dadurch gekennzeichnet, daß die Steuerschaltung $M_2$ drei Transistoren umfaßt die zum einen an einem Punkt V mit der letzten Kapazität $C_6$ und zum anderen bezüglich des Transistors $T_{21}$ mit dem Potential $V_g$, bezüglich $T_{22}$, dessen Steuerelektrode mit $V_{DD}$ verbunden ist, mit dem Potential $V_{DD}$ bzw. bezüglich $T_{23}$ mit dem Bezugspotential verbunden sind, wobei die Transistoren $T_{21}$ und $T_{23}$ periodisch an ihren Steuerelektroden gegebene Potentials ($\phi_B$, $\phi_3$) empfangen.

10. Filter nach einem der Ansprüche 3 bis 9, dadurch gekennzeichnet, daß die Transistoren vom MOS-Typ sind.

11. Filter nach Anspruch 5, dadurch gekennzeichnet, daß der Transistor $T_4$ vom MOS-Verarmungstyp ist.

# 0 012 667

## Claims

1. Method of filtering an electric signal by transfer of charges in a semiconductor substrate, said substrate being covered by a first insulating layer on which a first series of electrodes is arranged forming charge storage capacitances together with the first insulating layer, a second series of electrodes being inserted into one another with the first from which it is separated by a second insulating layer, the electrodes of this second series together with the first and second insulating layer and with the substrate forming interrupters controlling the charge transfer between the storage capacitances, this method being characterized during the treatment of each sample of the electric input signal by the following steps:

a) introduction of a charge quantity corresponding to the sample of the electric input signal which is being treated, under the first capacitance ($C_3$) in the direction of charge transfer;

b) under the last capacitance ($C_6$) in the direction of charge transfer, a charge quantity is introduced which is equal to that which was there during the treatment of the preceding sample of the electric input signal, prior to the beginning of the charge transfer of this last capacitance towards the means for converting the charges into an electric voltage;

c) establishment of a common surface potential between two successive capacitances, the capacitances being brought to a constant potential $V_g$ during this step;

d) transfer of the charges of the last capacitance in the direction of charge transfer towards the means for converting the charges into an electric voltage;

the order of steps a) and b) of the method being arbitrary, the steps a) and b), however, preceding step c) which precedes step d).

2. Method of filtering in accordance with claim 1, characterized in that it comprises, during the treatment of each sample of the electric input signal, a supplementary step e) during which a common surface potential is established between one of the charge storage capacitances ($C_4$) which assures the looping of the filter, and the following capacitance in the direction of charge transfer, these capacitances being brought to the voltages $V_g + \Delta V_s$ and $V_g$, respectively, during this step, wherein $\Delta V_s$ is the variation of the output voltage of the filter for the preceding sample of the electric input signal, the order of steps a), b) and e) of the method being arbitrary, the steps a), b) and e), however, preceding step c) which precedes step d).

3. Switched capacitance filter using a filtering method in accordance with claim 1 or 2, characterized in that it comprises a diode (D) implanted within the semiconductor substrate (1) and brought to a constant potential $V_D$, and a gate ($G_c$) lying within the same plane as the storage capacitances ($C_3$, $C_4$, $C_5$, $C_6$) and brought to a constant potential $V_{DD}$ exceeding $V_D$, which controls the current delivered by the diode, the gate being separated from the first capacitance in the direction of charge transfer by an interrupter $I_1$ located in the same plane as the other interrupters ($I_5$, $I_6$, $I_7$), and the first capacitance being connected with the common point of two series-connected transistors $T_1$ and $T_2$ respectively connected to the electric input signal E and to the voltage $V_g$, the transistors $T_1$ and $T_2$ and the interrupter $I_1$ being submitted to periodic potentials ($\phi_A$, $\phi_B$) such that during step a) of the method, the transistor $T_1$ will be conducting and the interrupter $I_1$ will be closed, and during step c) the transistor $C_2$ will be conducting.

4. Switched capacitance filter in accordance with claim 3, characterized in that the means converting the charges to an electric voltage comprise a charge reading capacity $C_l$ located within the same plane as the other storage capacitances and separated from the last storing capacitance ($C_6$) in the direction of charge transfer by an interrupter $I_3$ lying within the same plane as the other interrupters, the surface potential of the substrate beyond the reading capacitance being fixed to zero by an interrupter $I_4$ lying in the same plane as the other interrupters, followed by a zone of same conductivity as the substrate, but heavily doped, which is implanted below the substrate surface, the interrupter $I_4$ and the heavily doped zone being brought to the reference potential of the substrate, and characterized in that the reading capacitance is connected at point P to a circuit R which, during step d) of the method, maintains point P on a constant potential by withdrawing charges from a capacitance $C_A$, and delivers the output voltage $V_s(t)$ of the filter.

5. Filter in accordance with claim 4, characterized in that the circuit R comprises a transistor $T_4$ connected to point P and in series with one of the terminals of the capacitance $C_A$, a control circuit $M_1$ being connected to the common point of the transistor and the capacitance and a transistor $T_6$ being connected between the other terminal of the capacitance, point B, and a fixed potential $V_p$, and in that the transistors $T_4$ and $T_6$ and a control circuit $M_1$ are submitted to periodic potentials ($\phi_2$, $\phi_A$, $\phi_B$) such that, successively:

— point B is brought to potential $V_p$ by the transistor $T_6$;

— the control circuit $M_1$ assures charging of the capacitance $C_A$ and of the reading capacitance $C_l$ through the transistor $T_4$ and then the saturation of the transistor $T_4$;

— during step d) of the method, the transistor $T_4$ is saturated, maintaining a constant potential at point

12

P by withdrawing charges from the capacitance $C_A$, and the potential of point A, initially on $V_{AO}$, is reduced;

— by the blocking of the transistors $T_6$ and $T_4$, the potential at point B becomes floating and insulates points A and P;

— during step e) of the method, the point A is brought to the potential $V_g$ by the control circuit $M_1$, and the potential at point B is $V_g + \Delta V_s$, the potentials $V_p$ and $V_{AO}$ being equal and wherein $\Delta V_s$ is the output voltage variation of the filter for the preceding sample of the electric input signal, this potential $V_g + \Delta V_s$ being applied to the capacitance ($C_4$) assuring the looping of the filter.

6. Filter in accordance with claim 5, characterized in that the control circuit $M_1$ comprises a transistor $T_5$ between point A and the fixed potential $V_g$ and a transistor $T_7$ between the point A and the point g, the gate of $T_7$ being connected to point g, as well as a capacitance $C_g$ and a transistor $C_8$ the two other terminals of which are brought to potential $V_g$, the gate of $T_5$ and the capacitance $C_g$ receiving periodically given potentials ($\phi_A$, $\phi_B$).

7. Filter in accordance with any of claims 4, 5 or 6, characterized in that one transistor $T_3$ is connected between the point P and the reference voltage, this transistor $T_3$ periodically receiving a given potential ($\phi_3$) on its gate causing step b) of the method to proceed.

8. Filter in accordance with claim 3, characterized in that the last storage capacitance ($C_6$) in the direction of charge transfer is connected to a control circuit $M_2$, and in that the means for converting the charges into an electric voltage comprise a reading diode $D_l$ integrated within the semiconductor substrate and separated from the last capacitance by an interrupter $I_3$ lying within the same plane as the other interrupters, the diode $D_l$ being connected to a point P to which are connected a transistor $T_{12}$ between the point P and the potential $V_g$ and a stage having the gain k, between the point P and a point Q, a transistor $T_{40}$ being located in series with one of the terminals of a capacitance $C_A$ between the point Q and a point B, a transistor $T_5$ being connected between the common point A of $T_{40}$ and $C_A$ and the potential $V_g$, and a transistor $T_6$ being connected between the point B and the potential $V_p$, the control circuit $M_2$, the interrupter $I_3$ and the transistors $T_{40}, T_5, T_6$ being submitted to periodic potentials ($\phi_A$, $\phi_B$, $\phi_1$, $\phi_3$) such that, successively:

— the control circuit $M_2$ brings the last capacitance to the potential $V_g$ and the step c) of the method proceeds;

— the control circuit $M_2$ brings the last capacitance to the potential $V_{DD}$, the interrupter $I_3$ being brought to the potential $V_g$, and the point B is brought to the potential $V_p$ by transistor $T_6$;

— the control circuit $M_2$ brings the last capacitance to the reference potential, the step d) of the method proceeding and the potential at A, initially on $V_{AO}$, evolving;

— the blocking of transistor $T_{40}$ insulates the points A and Q, the control circuit $M_2$ bringing the last capacitance to the potential $V_{DD}$, and the step d) of the method proceeding;

— the steps a) and e) of the method proceed, the point A is brought to the potential $V_g$ by the transistor $T_5$, the potential of the point B is equal to $V_g + \Delta V_s$, the potentials $V_p$ and $V_{AO}$ being equal and wherein $\Delta V_s$ is the output voltage variation of the filter for the preceding sample of the electric input signal, the potential $V_g + \Delta V_s$ being applied to the capacitance ($C_4$) assuring the looping of the filter, and finally, the diode $D_l$ is restored to the potential $V_g$ by the transistor $T_{12}$.

9. Filter in accordance with claim 8, characterized in that the control circuit $M_2$ comprises three transistors connected to the last capacitance $C_6$ at a point V, on the one hand, and on the other hand to potential $V_g$ with respect to transistor $T_{21}$, to the potential $V_{DD}$ with respect to $T_{22}$ the gate of which is connected to $V_{DD}$, and to the reference potential with respect to $T_{23}$, the transistors $T_{21}$ and $T_{23}$ periodically receiving given potentials ($\phi_B$, $\phi_3$) on their gates.

10. Filter in accordance with any of claims 3 to 9, characterized in that the transistors are of MOS type.

11. Filter in accordance with claim 5, characterized in that the transistor $T_4$ is of MOS depletion type.

# FIG_1

# FIG_3

## FIG.3·a

$\phi_A$

## FIG.3·b

$\phi_B$

$t_1$ $t_2$ $t_3$ $t_4$ $t_5$

## FIG.3·c

$\phi_L$

# FIG_4

FIG_2

$\phi_L$ $T_1$ $T_2$ $\phi_B$ FIG.2-a

FIG.2-b

FIG.2-c

FIG.2-d

FIG.2-e

FIG.2-f

# FIG_5

# FIG_7

0 012 667

FIG_6

FIG_6-a

FIG_6-b

FIG_6-c

FIG_6-d

FIG_6-e

4